Europäisches Patentamt

European Patent Office

Office européen des brevets

(11) Veröffentlichungsnummer: **0 414 039 A2**

# (12) EUROPÄISCHE PATENTANMELDUNG

(21) Anmeldenummer: 90115157.1

(22) Anmeldetag: 07.08.90

(51) Int. Cl.⁵: **G01R 19/02**

(30) Priorität: **25.08.89 DE 3928083**

(43) Veröffentlichungstag der Anmeldung:
**27.02.91 Patentblatt 91/09**

(84) Benannte Vertragsstaaten:
**DE FR GB IT**

(71) Anmelder: **Rohde & Schwarz GmbH & Co. KG**
**Mühldorfstrasse 15**
**D-8000 München 80(DE)**

(72) Erfinder: **Reichel, Thomas, Dipl.-Ing.**
**Alpenrosenstrasse 10**
**D-8011 Baldham(DE)**

(74) Vertreter: **Graf, Walter, Dipl.-Ing.**
**Sckellstrasse 1**
**D-8000 München 80(DE)**

(54) **Schaltung zum Messen einer von dem quadratischen Mittelwert einer Wechselspannung abgeleiteten Messgrösse, insbesondere des Effektivwerts einer Wechselspannung.**

(57) Zum Messen des Effektivwertes einer Wechselspannung in einem von sehr niedrigen bis sehr hohen Frequenzen reichenden Frequenzbereich wird die zu messende Wechselspannung mittels einer Frequenzweiche in einen niederfrequenten und in einen höherfrequenten Spannungsanteil aufgeteilt; der niederfrequente Spannungsanteil wird nach Digitalisierung rechnerisch quadriert und der höherfrequente Spannungsanteil wird mittels einer analogen Quadrierschaltung quadriert und erst anschließend digitalisiert; diese beiden Digitalwerte werden zu einem Gesamtwert addiert, aus welchem durch Mittelwertbildung die gewünschte Meßgröße errechnet wird.

EP 0 414 039 A2

EP 0 414 039 A2

## SCHALTUNG ZUM MESSEN EINER VON DEM QUADRATISCHEN MITTELWERT EINER WECHSELSPANNUNG ABGELEITETEN MESSGRÖSSE, INSBESONDERE DES EFFEKTIVWERTS EINER WECHSELSPANNUNG

Die Erfindung betrifft eine Schaltung zum Messen einer von dem quadratischen Mittelwert einer Wechselspannung abgeleiteten Meßgröße, beispielsweise der Signalleistung, insbesondere aber des Effektivwerts einer Wechselspannung.

Die bisher üblichen analogen Meßschaltungen benutzen zur Quadrierung der Meßspannung Gleichrichter beispielsweise mit thermischen Gleichrichterelementen oder Halbleiter-Bauelementen (z.B. nach DE-PS 23 29 579 oder 31 43 669). Die im Ausgangssignal dieser Quadrierer enthaltenen zeitabhängigen Komponenten (Grundfrequenz und Harmonische der Meßspannung) werden für eine beruhigte Anzeige durch ein nachgeschaltetes, an die niedrigste vorkommende Meßfrequenz angepaßtes Tiefpaßfilter unterdrückt. Die durch das Tiefpaßfilter hervorgerufene Anzeigeträgheit nimmt in dem Maße zu, wie die untere Frequenzgrenze herabgesetzt wird. Das führt bei niedrigen Fre quenzen zu extrem langen Einschwingzeiten; zum Messen einer Wechselspannung von 1 Hz sind beispielsweise 10 s oder mehr nötig, zum Messen einer Spannung mit nur 0,1 Hz sogar 100 s oder mehr, d.h. mindestens 10 Perioden. Diese bekannten analog arbeitenden Quadrierschaltungen messen außerdem i.a. auch noch den Gleichspannungsanteil mit, da Hochpässe zum Abtrennen des Gleichspannungsanteils wegen der bei niedrigen Frequenzen sehr großen Kondensatoren zu aufwendig sind.

Es ist auch schon bekannt, die Quadrierung der zu messenden Wechselspannung rechnerisch durchzuführen (Field, B.F: A Fast Response Low-Frequency Voltmeter. IEEE Transactions on Instrumentation and Measurement. Vol. IM-27, No. 4, December 1978, S. 368-372). Die zu messende Wechselspannung wird durch eine Abtast-Halte-Schaltung abgetastet, die Abtastwerte werden durch einen A/D-Wandler digitalisiert und dieser Digitalwert wird dann rechnerisch quadriert und daraus der Mittelwert gebildet. Mit diesem bekannten Verfahren kann die Meßzeit zwar extrem klein gehalten werden, es kann beispielsweise bereits nach zwei Perioden des Meßsignals der Meßwert angezeigt werden und auch Gleichspannungsanteile können mit diesem bekannten Verfahren auf einfache Weise unterdrückt werden. Dieses bekannte Verfahren ist jedoch nur für sehr niedrige Frequenzen geeignet, da beispielsweise zum Abtasten einer Meßspannung von 100 Hz Abtastraten im kHz-Bereich und damit extrem schnelle A/D-Wandler mit angepaßten Auswertschaltungen nötig sind.

Es ist Aufgabe der Erfindung, eine im Aufbau einfache Schaltung zum Messen einer von dem quadratischen Mittelwert einer Wechselspannung abgeleiteten Meßgröße, insbe sondere des Effektivwerts einer Wechselspannung, zu schaffen, die in einem breiten Frequenzbereich von sehr niedrigen Frequenzen, beispielsweise nur Bruchteilen von Hz, bis zu sehr hohen Frequenzen, beispielsweise bis einigen MHz, eine sehr schnelle Messung und Meßwertanzeige ermöglicht.

Diese Aufgabe wird ausgehend von einer Schaltung laut Oberbegriff des Hauptanspruches durch dessen kennzeichnende Merkmale gelöst. Vorteilhafte Weiterbildungen ergeben sich aus den Unteransprüchen.

Die erfindungsgemäße Schaltung ermöglicht die Realisierung beispielsweise eines Effektivwertmessers, der in einem breiten Frequenzbereich von beispielsweise 0,01 Hz bis 30 MHz eine schnelle Meßwertanzeige ermöglicht. Der Frequenzbereich ist nach unten durch das in diesem Teilbereich angewendete rechnerische Quadrierverfahren unbegrenzt, nach oben ist dieser Frequenzbereich nur bestimmt durch den im höherfrequenten Teilbereich benutzten analogen Quadrierer. Die Abtastfequenz des numerisch arbeitenden Quadrierers wird nur noch durch die Grenzfrequenz und Charakteristik der Frequenzweiche bestimmt, bei Wahl einer niedrigen Grenzfrequenz dieser Frequenzweiche, beispielsweise von nur 7 Hz, ergeben sich Abtastraten im Bereich einiger 100 Hz, so daß die digitale Signalverarbeitung in dieser Quadrierschaltung mit handelsüblichen Mikroprozessoren durchgeführt werden kann. Die Einschwingzeiten bei dieser Dimensionierung liegen dabei unter einer Sekunde, d.h. die Meßwertverarbeitung beginnt praktisch sofort. Durch die numerische Meßwertverarbeitung kann die Mittelwertsbildung der Abtastwerte über eine Periode der Meßfrequenz durchgeführt werden, so daß sich insgesamt sehr kurze Meßzeiten ergeben. Zusätzlich besitzt die erfindungsgemäße Schaltung den Vorteil, daß überlagerte Gleichspannungsanteile auf einfache Weise ohne zusätzlichen Schaltungsaufwand unterdrückt werden können. Eine erfindungsgemäße Schaltung kann praktisch ohne Mehraufwand in ein bekanntes Breitband-RMS-Voltmeter, das für höhere Frequenzen bereits die analoge Quadrierschaltung aufweist, im Niederfrequenzbereich erweitert werden. Die erfindungsgemäße Schaltung ist für alle Meßaufgaben geeignet, bei denen aus dem quadratischen Mittelwert einer Eingangswechselspannung gewünschte Meßgrößen ermittelt werden sollen, dies ist in der Hochfrequenztechnik beispielsweise bei der Leistungsmessung oder zur Effektivwertmessung der Fall. Als analoge Quadrierschal-

2

tung sind alle bekannten Schaltungen dieser Art geeignet, beispielsweise auch Gleichrichterschaltungen mit thermischen Gleichrichterelementen oder Halbleiter-Gleichrichterelementen.

Die Erfindung wird im folgenden anhand schematischer Zeichnungen an einem Ausführungsbeispiel näher erläutert.

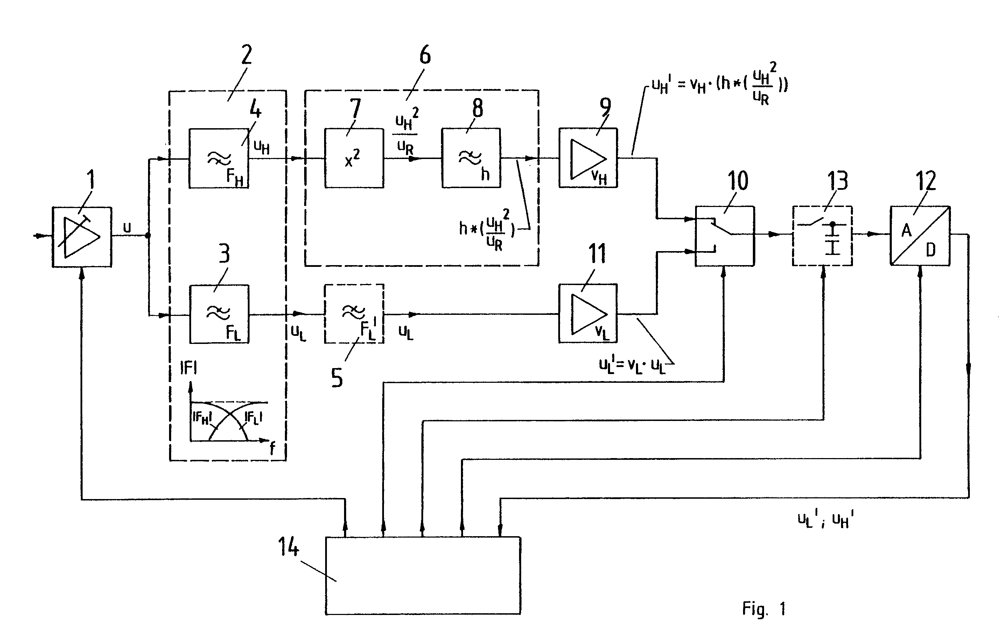

Fig. 1 zeigt das Prinzipschaltbild einer erfindungsgemäßen Schaltung zum Messen des Effektivwerts einer Eingangsspannung u. Die Eingangsspannung u wird über einen einstellbaren Verstärker 1 einer Frequenzweiche 2 zugeführt, die den Gesamtfrequenzbereich der zu messenden Wechselspannung u von beispielsweise 0,01 bis 30 MHz in einen niederfrequenten Anteil $u_L$ von beispielsweise 0,01 bis 7 Hz und in einen höherfrequenten Anteil $u_H$ von 7 bis 30 MHz aufteilt. Die Frequenzweiche ist von bekannter Bauart, in dem gezeigten Ausführungsbeispiel ist sie durch einen Tiefpaß 3 und einen Hochpaß 4 realisiert, diese beiden Filter 3 und 4 sind so bemessen, daß die Summe der beiden Leistungsanteile gleich der eingangsseitigen Gesamtleistung ist nach der Beziehung

$$|F_L(f)|^2 + |F_H(f)|^2 = 1 \qquad (1)$$

wobei $F_L$ die Übertragungsfunktion des Filters 3 und $F_H$ die des Filters 4 ist. Dieses gewünschte Filterverhalten kann am einfachsten mit sogenannten Butterworth-Filtern gleicher Ordnung N und 3-dB-Grenzfrequenz $f_g$ erreicht werden, für das Betragsquadrat der Übertragungsfunktionen $F_L$ und $F_H$ gilt:

$$\left| F_L(f) \right|^2 = \frac{1}{1 + (f/f_g)^{2N}} \qquad (2)$$

$$\left| F_H(f) \right|^2 = \frac{(f/f_g)^{2N}}{1 + /f/f_g)^{2N}} \qquad (3)$$

damit ist Forderung nach Gleichung (1) erfüllt.

Die Unterdrückung höherfrequenter Komponenten im niederfrequenten Spannungsanteil $u_L$ ist bei gegebener Grenzfrequenz $f_g$ um so besser, je höher die Ordnung N des Filterpaares 3,4 ist. Im Interesse niedriger Abtastfrequenzen sollte N daher möglichst hoch gewählt werden. Dem steht entgegen, daß ein Abgleich der beiden Filter zur Erfüllung der Gleichung (1) mit zunehmender Ordnung N wegen der ebenfalls zunehmenden Zahl von Abgleichelementen immer schwieriger wird. Wird auf einen Abgleich verzichtet, so müssen mit steigender Ordnung N immer enger tolerierte Bauelemente verwendet werden. Es ist daher sinnvoll, den Filtergrad N klein zu wählen und statt dessen ein unkritisches Anti-Aliasing-Filter 5 im niederfrequenten Signalzweig vorzusehen. Dieses Filter ändert zwar prinzipiell die Übertragungsfunktion im niederfrequenten Signalzweig und führt zu einer Verfälschung der Gleichung (1), dies kann jedoch dadurch gemindert werden, daß die Grenzfrequenz des Anti-Aliasing-Filters 5 groß gegenüber der Grenzfrequenz des vorhergehenden Tiefpaßfilters 3 gewählt wird. Am einfachsten ist es, die Weiche mit einem einpoligen Tiefpaßfilter 3 und einem einpoligen Hochpaßfilter 4 gleicher Grenzfrequenz $f_g$ aufzubauen, den Filtergrad also zu N = 1 zu wählen. Anstelle von zwei getrennten Filtern 3 und 4 kann natürlich auch jede andere Filteranordnung benutzt werden, welche die gewünschte Hochpaß-Tiefpaß-Eigenschaft besitzt.

Die Grenzfrequenz $f_g$ der Weiche 2 sollte im Interesse schnellen Einschwingverhaltens möglichst hoch gewählt werden. Da proportional zu $f_g$ auch die Abtastfrequenz und damit der Aufwand an digitaler Signalverarbeitung steigt, ist hier jedoch ein Kompromiß nötig. In einem praktischen Ausführungsbeispiel wurde die Grenzfrequenz $f_g$ zu 7 Hz gewählt und die beiden Filter 3 und 4 mit N = 1 als einpolige Filter ausgebildet, dadurch wird erreicht, daß die Frequenzweiche in 0,16 s auf 0,1 % einschwingt. Mit einem dreipoligen Anti-Aliasing-Filter kann bei dieser Dimensionierung die Abtastfrequenz mit 325 Hz gewählt werden.

Der höherfrequente Spannungsanteil $u_H$ am Ausgang der Weiche 2 wird einer bekannten analog arbeitenden Quadrierschaltung 6 zugeführt, die in dem gezeigten Ausführungsbeispiel aus einem analogen Quadrierer 7 mit nachgeschaltetem Tiefpaßfilter 8 (Impulsantwort h(t)) besteht. Wegen des Hochpaßfilters 4 der Weiche braucht der Quadrierer 7 nicht für die Verarbeitung von Gleichspannungen ausgelegt zu sein, die Quadrierschaltung 7 ist beispielsweise nach DE-PS 23 29 579 mit Halbleiter-Bauelementen aufgebaut, gegebenenfalls auch mit einer Korrekturschaltung nach DE-PS 31 43 669. Das nachgeschaltete Tiefpaßfilter 8 braucht nur die höherfrequenten Komponenten zu unterdrücken, da die anderen Anteile zusammen mit den quadrierten Abtastwerten des niederfrequenten Signalzweiges in der nachfolgend beschriebenen numerischen Signalaufbereitung gefiltert werden. Die Grenzfrequenz und der Filtergrad des Tiefpaßfilters 8 sind so zu wählen, daß sich eine möglichst kurze Einschwingzeit ergibt, höherfrequente Komponenten

3

müssen so stark unterdrückt werden, daß sich keine Abtastfehler ergeben. Signale mit hohen Scheitelfaktoren müssen außerdem so gefiltert werden, daß der Aussteuerungsbereich des nachfolgenden A/D-Wandlers nicht überschritten wird.

Die quadrierte Ausgangsspannung der analogen Quadrierschaltung 6 des höherfrequenten Signalzweiges wird über einen Verstärker 9 einem Multiplexer 10 zugeführt, der niederfrequente Spannungsanteil $u_L$ vom Ausgang des Filters 5 über einen Verstärker 11 dem anderen Eingang des Multiplexers 10. Die beiden Verstärker 9 und 11 sind gleichspannungsgekoppelt, sie dienen zur Anpassung an den Aussteuerbereich des nachfolgenden gemeinsamen A/D-Wandlers 12. Die Baugruppen 3,5 und 11 bzw. 8 und 9 können auch in vertauschter Reihenfolge angeordnet sein, falls dies aus technischen Gründen vorteilhaft ist.

Die Ausgangsspannungen der beiden Verstärker 9 und 11 werden über den Multiplexer 10 zeitversetzt dem A/D-Wandler 12 zugeführt. Wenn die Wandlungszeit zu groß ist, kann dem A/D-Wandler 12 noch ein Abtast-Halte-Glied 13 vorgeschaltet sein. Der Zeitversatz des Multiplexers ist unkritisch, er richtet sich nach der dielektrischen Absorption des Haltekondensators, der Wandlungszeit und der Verarbeitungszeit des nachfolgenden Mikroprozessors. Anstelle des Multiplexers mit gemeinsamem A/D-Wandler könnte selbstverständlich auch jede der Ausgangsspannungen der Verstärker 9 und 11 über einen gesonderten A/D-Wandler möglicherweise mit vorgeschaltetem Abtast-Halte-Glied digitalisiert werden.

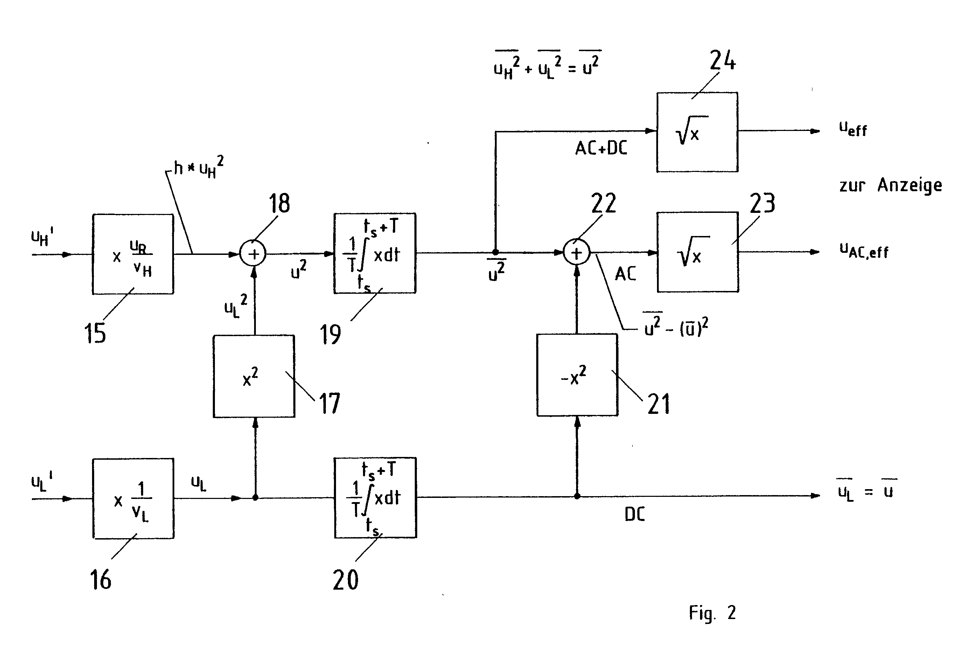

Die Digitalwerte $u_L'$ und $u_H$ vom Ausgang des A/D-Wandlers 12 werden einem Mikroprozessor 14 zugeführt, in welchem die in Fig. 2 näher dargestellte numerische Meßwertverarbeitung durchgeführt wird. Durch diesen Mikroprozessor 14 wird auch die Einstellung des Eingangsverstärkers 1, die Steuerung der Abtastung über den Multiplexer 10 und das Abtast-Halte-Glied 13 und die A/D-Wandlung im Wandler 12 gesteuert.

Nach Fig. 2 werden in einem ersten Schritt 15 und 16 die für die A/D-Wandlung notwendigen Verstärkungen $v_H$ und $v_L$ wieder rückgängig gemacht und so im niederfrequenten Zweig $u_L$ und im höherfrequenten Zweig die quadrierte und durch den Tiefpaß 8 vorgefilterte Spannung $h * u_H^2$ (mit h = Impulsantwort des Tiefpasses 8 und * dem Faltungsoperator) gewonnen. Die Vorfilterung im Tiefpaß 8 hat, abgesehen von den für seine Dimensionierung aufgeführten Gesichtspunkten, keinen Einfluß auf den weiteren Rechenvorgang, so daß vereinfachend von $u_H^2$ statt von $h * u_H^2$ ausgegangen wird. In einem Rechenschritt 17 wird der niederfrequente Spannungsanteil $u_L$ quadriert und in einem Addierschritt 18 dem quadrierten Spannungsanteil $u_H^2$ des höherfrequenten Meßzweiges hinzuaddiert. Dieser neue Gesamtwert $u^2$ wird durch Mittelwertbildung 19 über die Zeit T gemittelt. In gleicher Weise wird der niederfrequente Spannungsanteil $u_L$ durch einen Rechenschritt 20 über die Zeit T gemittelt. Die beiden als Mittelungsfilter arbeitenden Rechenschritte 19 und 20 arbeiten auf gleiche Weise, es wird eine numerische Integration über die Zeit T und eine Division des Integrals durch die Integrationszeit T durchgeführt. Wenn T kein ganzzahliges Vielfaches der Abtastperiode $T_A$ ist, so ist über die restliche Zeit nach vorhergehender Interpolation zwischen den letzten Abtastwerten zu integrieren. Die Integration ist um die Einschwingzeit $t_s$ verzögert nach einer Änderung der Meßgröße zu beginnen. Bei periodischen Signalen genügt es, die Integration über eine Periode der Meßspannung oder ein ganzzahliges Vielfaches davon vorzunehmen. Bei nichtperiodischen stationären Signalen wie Rauschen wird die Meßanzeige um so ruhiger, je größer T gewählt wird. Wenn nur der Wechselspannungsanteil AC des Meßsignales bestimmt werden soll wird mit 1/T eine untere Grenzfrequenz festgelegt. Je kleiner 1/T ist, um so mehr niederfrequente Komponenten können erfaßt werden. Bei periodischen Signalen kann T fest vorgegeben oder im Rahmen des Meßablaufes bestimmt werden. Im letzteren Fall wird die Integration gestartet, wenn das Signal des niederfrequenten Meßzweiges einen vorgegebenen Schwellwert über- oder unterschreitet, die Integration wird beendet, wenn der Auslösepunkt zum n-ten Male erreicht wird.

Mit der Mittelwertbildung 19,20 stehen digitale Meßwerte für die Weiterverarbeitung und Berechnung der verschie densten Meßgrößen zur Verfügung. Durch zusätzliche Quadrierung 21 des durch Mittelwertbildung 20 gewonnenen Gleichspannungsanteiles DC im niederfrequenten Zweig und Subtraktion 22 dieses Wertes von dem gemittelten Gesamtwert $\overline{u^2}$ wird der reine quadratische Wechselspannungsanteil erhalten, der durch Radizierung 23 in den Effektivwert des reinen Wechselspannungsanteils der Eingangsspannung u umgerechnet werden kann. Durch Radizierung 24 des Mittelwertes $\overline{u^2}$ kann der Effektivwert der Eingangsspannung einschließlich Gleichspannungsanteil gewonnen werden, durch Radizierung 23 des quadratischen Wechselstromanteiles kann der Effektivwert ohne Gleichspannungsanteil errechnet werden. Der rein quadratische Wechselspannungsanteil nach der Subtraktion 22 kann beispielsweise unmittelbar zur Berechnung und Anzeige der Wechselstromleistung herangezogen werden. Die rechnerisch sehr schnell ermittelten Meßgrößen können dann unmittelbar weiterverarbeitet oder angezeigt werden.


**Ansprüche**

4

1. Schaltung zum Messen einer von dem quadratischen Mittelwert einer Wechselspannung (u) abgeleiteten Meßgröße, insbesondere des Effektivwertes ($u_{eff}$) einer Wechselspannung in einem von sehr niedrigen bis sehr hohen Frequenzen reichenden Frequenzbereich (0,01 bis 30 MHz), dadurch **gekennzeichnet,**

daß die zu messende Wechselspannung (u) mittels einer Frequenzweiche (2) in einen niederfrequenten und in einen höherfrequenten Spannungsanteil ($u_L$, $u_H$) aufgeteilt wird und die Frequenzweiche dabei so bemessen ist, daß die Summe ihrer beiden Leistungsanteile gleich der eingangsseitigen Gesamtleistung ist, der niederfrequente Spannungsanteil nach Digitalisierung (12) in an sich bekannter Weise rechnerisch quadriert wird (Rechenschritte 16,17),

der höherfrequente Spannungsanteil ($u_H$) mittels einer bekannten analogen Quadrierschaltung (6) quadriert und anschließend digitalisiert wird (Wandler 12),

und

diese beiden Digitalwerte ($u_H^2$, $u_L^2$) zu einem Gesamtwert ($u^2$) addiert werden, aus welchem durch Mittelwertbildung (19) die gewünschte Meßgröße (z.B. $u_{eff}$) errechnet wird.

2. Schaltung nach Anspruch 1, dadurch **gekennzeichnet,** daß durch rechnerische Radizierung (24) aus dem Mittelwert des Gesamtwertes ($\overline{u^2}$) der Effektivwert ($u_{eff}$) einschließlich Gleichspannungsanteil (DC) errechnet wird.

3. Schaltung nach Anspruch 1 oder 2, dadurch **gekennzeichnet,** daß durch Mittelwertbildung (20) aus dem Digitalwert ($u_L$) des niederfrequenten Spannungsanteiles der Gleichstromanteil (DC) errechnet wird.

4. Schaltung nach Anspruch 3, dadurch **gekennzeichnet,** daß durch Subtraktion des Quadrates (21) des Gleichstromanteiles (DC) vom Mittelwert des Gesamtwertes ($\overline{u^2}$) und anschließende numerische Radizierung (23) der Effektivwert ($U_{AC,eff}$) des Wechselspannungsanteiles errechnet wird.

5. Schaltung nach Anspruch 3, dadurch **gekennzeichnet,** daß durch Subtraktion des Quadrates (21) des Gleichstromanteiles (DC) vom Mittelwert des Gesamtwertes ($\overline{u^2}$) die Wechselstromleistung errechnet wird.

6. Schaltung nach einem der vorhergehenden Ansprüche, dadurch **gekennzeichnet,** daß die Frequenzweiche (2) durch ein Tiefpaß- (3) und ein Hochpaß-Filter (4) gebildet ist.

7. Schaltung nach Anspruch 6, dadurch **gekennzeichnet,** daß die beiden Filter (3,4) Butterworth-Filter gleicher Ordnung (N) und gleicher Grenzfrequenz ($f_g$) sind.

8. Schaltung nach Anspruch 6 oder 7, dadurch **gekennzeichnet,** daß die Weiche (2) durch einen einpoligen Tiefpaß (3) und einen einpoligen Hochpaß (4) gleicher Grenzfrequenz ($f_g$) gebildet ist.

9. Schaltung nach einem der Ansprüche 6, 7 oder 8, dadurch **gekennzeichnet,** daß im niederfrequenten Meßzweig hinter dem Tiefpaß (3) ein Anti-Aliasing-Filter(5) angeordnet ist.

10. Schaltung nach einem der vorhergehenden Ansprüche, dadurch **gekennzeichnet,** daß der Tiefpaß (8) der analogen Quadrierschaltung (6) so bemessen ist, daß er diejenigen hochfrequenten Komponenten unterdrückt, die nicht durch die anschließende rechnerische Mittelwertbildung (19,20) unterdrückt werden.

11. Schaltung nach einem der vorhergehenden Ansprüche, dadurch **gekennzeichnet,** daß die Digitalisierung des niederfrequenten und höherfrequenten Spannungsanteiles in einem gemeinsamen A/D-Wandler (12) erfolgt, an den über einen Multiplexer (10) wechselweise die analoge Quadrierschaltung (6) bzw. der niederfrequente Ausgang der Weiche (2) anschaltbar ist.

12. Schaltung nach einem der vorhergehenden Ansprüche, dadurch **gekennzeichnet,** daß der Mittelwert des digitalen Gesamtwertes und/oder der Mittelwert des niederfrequenten Digitalwertes durch Integration und Division durch die Integrationszeit (T) gebildet wird (Mittelwertbildung 19,20).

Fig. 1

Fig. 2

$\overline{u_H{}^2} + \overline{u_L{}^2} = \overline{u^2}$

$h * u_H{}^2$

$u_H{}'$

$x \dfrac{u_R}{v_H}$   15

18

$\dfrac{1}{T}\displaystyle\int_{t_s}^{t_s+T} x\,dt$   19

$\overline{u^2}$

22

AC+DC

$\sqrt{x}$   24

$u_{eff}$

zur Anzeige

$u_L{}^2$

$x^2$   17

AC

$\sqrt{x}$   23

$u_{AC,eff}$

$\overline{u^2} - (\bar{u})^2$

$-x^2$   21

$u_L{}'$

$x \dfrac{1}{v_L}$   16

$u_L$

$\dfrac{1}{T}\displaystyle\int_{t_s}^{t_s+T} x\,dt$   20

DC

$\overline{u_L} = \bar{u}$

EP 0 414 039 A2